Europäisches Patentamt

European Patent Office

Office européen des brevets

(19)

(11) Numéro de publication : **0 044 247 B1**

## (12) FASCICULE DE BREVET EUROPÉEN

(45) Date de publication du fascicule du brevet :
30.10.85

(21) Numéro de dépôt : **81401089.8**

(22) Date de dépôt : **07.07.81**

(51) Int. Cl.⁴ : **H 05 K 3/40**

(54) **Procédé de fabrication d'un support de composants électroniques pour la connexion des supports de puces de circuits intégrés.**

(30) Priorité : **11.07.80 FR 8015493**

(43) Date de publication de la demande :
**20.01.82 Bulletin 82/03**

(45) Mention de la délivrance du brevet :
**30.10.85 Bulletin 85/44**

(84) Etats contractants désignés :
**DE FR GB IT**

(56) Documents cités :
**FR-A- 1 532 026**

(73) Titulaire : **SOCAPEX**
**10 bis, quai Léon Blum**
**F-92153 Suresnes (FR)**

(72) Inventeur : **Mariotte, Jean-Marie**
**THOMSON-CSF SCPI 173 bd Haussmann**
**F-75360 Paris Cedex 08 (FR)**
Inventeur : **Hamaide, Pierre**
**THOMSON-CSF SCPI 173 bd Haussmann**
**F-75360 Paris Cedex 08 (FR)**

(74) Mandataire : **Ruellan-Lemonnier, Brigitte et al**
**THOMSON-CSF SCPI 173, boulevard Haussmann**
**F-75379 Paris Cedex 08 (FR)**

Jouve, 18, rue St-Denis, 75001 Paris, France

EP 0 044 247 B1

**0 044 247**

**Description**

L'invention concerne un procédé de fabrication d'un support pour composants électroniques du type connu sous l'appellation « circuits imprimés » et permettant la connexion directe des composants tels que les « puces » de circuits intégrés en boîtiers ou « chip-carrier », selon l'appellation anglosaxonne qui sera utilisée dans toute la suite de l'exposé pour désigner ce type de composants.

Ces « chip-carrier » sont habituellement constitués d'un substrat en céramique en forme de cuvette dont le fond est revêtu de métallisations auxquelles les zones de contact de la puce semi-conductrice sont reliées électriquement par thermo-compression ou soudure ultrasons. Ces zones de métallisations internes à la cuvette sont elles-mêmes reliées à des zones de métallisations externes disposées sous le substrat, ces zones de métallisations étant habituellement soudées sur un support de circuit hybride. Ce support de circuit hybride porte par ailleurs un certain nombre de composants discrets tels que self-inductances, résistances, capacités, etc... ces différents composants étant rapportés sur la surface du support de circuit hybride qui comporte également les différentes métallisations nécessaires à leur interconnexion. Compte tenu des propriétés thermiques recherchées pour ces supports de circuits hybrides, ils sont généralement réalisés également en céramique. Ces circuits hybrides sont reliés à un circuit imprimé.

Or, la réalisation de circuits hybrides est particulièrement onéreuse puisque ces circuits sont réalisés sur substrat en céramique métallisée, les opérations de métallisation par dépôt étant longues et s'effectuant pièce par pièce. Par conséquent, on cherche actuellement à connecter directement les « chip-carrier » sur les circuits de type imprimé afin d'économiser plusieurs opérations et éviter l'utilisation d'un support supplémentaire. Toutefois, les caractéristiques mécaniques et thermiques des supports en céramiques des « chip-carrier » et celles des circuits imprimés, par exemple en résine époxy métallisée sont très différentes les unes des autres : en particulier le coefficient de dilatation thermique de ces supports sont très différents. Lorsque l'on soude directement un « chip-carrier » sur un circuit imprimé de structure bien connue de l'homme de métier et que l'on soumet ensuite l'ensemble à des contraintes climatiques élevées (température s'élevant rapidement aux environs de 100 °C), le support en époxy ainsi que le cuivre des connexions qui le recouvre s'allongent alors que la céramique ne subit qu'une très faible dilatation. Par conséquent, on constate un arrachement au niveau des soudures entre les « chip-carrier » et les conducteurs cuivrés. De même lorsque lesdits circuits imprimés sont soumis à des vibrations ou accélérations, la différence de comportement mécanique des céramiques d'une part et des matériaux des circuits imprimés d'autre part, provoque bien souvent une rupture des contacts électriques au niveau des soudures. Il est donc difficile avec la technique actuellement connue des circuits imprimés de connecter directement des « chip-carrier » sur ceux-ci et obtenir une bonne fiabilité des circuits ainsi réalisés.

Pour résoudre ce problème, il est connu de FR-A-1 532 026 de réaliser des doigts d'interconnexion disposés en porte à faux, venant se loger sous une puce sur des plôts de contact électriques. Pour cela, on dépose sur un substrat une couche inerte que l'on recouvre d'une couche métallique. Celle-ci est gravée pour former une pluralité de doigts d'interconnexion. Ceux-ci sont ensuite rendus indépendants du substrat par gravure sélective sous lesdits doigts, de manière à retirer la couche inerte.

L'invention propose un procédé de fabrication d'un support pour composants électroniques dans lequel un substrat et un feuillard de cuivre sont assemblés à l'aide d'une couche adhésive et dans lequel des contacts électriques destinés à la fixation desdits composants et possédant chacun une partie en porte-à-faux de longueur suffisante pour permettre d'adapter les caractéristiques mécaniques et thermiques du support et du composant sont élaborés par gravure du feuillard de cuivre, est caractérisé en ce que, avant les opérations d'assemblage, la couche adhésive est réalisée de façon discontinue afin de présenter des lacunes correspondant aux emplacements d'implantation de certains des composants, lesdites lacunes ayant des dimensions supérieures à celles desdits composants et étant repérées par des moyens de repérage permettant d'obtenir directement par gravure de la couche lesdites parties en porte-à-faux, disposées au-dessus desdites lacunes.

Selon un mode préférentiel de réalisation, une couche isolante est interposée entre la couche adhésive et le film métallique dans laquelle sont gravés les conducteurs.

La structure de circuit obtenue selon ce procédé permet en effet de résoudre le problème posé par les différences de dilatation du circuit imprimé d'une part et du support en céramique des puces semiconductrices ou « chip-carrier ». En effet, on constate que lorsqu'il y a dilatation du circuit imprimé aussi bien de ses parties isolantes que conductrices, il se produit un allongement des différentes couches de ce circuit. Du fait de l'absence de couches adhésives sous les conducteurs reliés au plot de contact du chip-carrier, lesdits conducteurs du fait de l'élévation de température, s'allongent dans une direction opposée à celle de l'allongement dudit circuit imprimé. Etant donné que le substrat en céramique a un très faible coefficient de dilatation thermique, il n'est soumis à aucun allongement sensible. Par conséquent, l'allongement des conducteurs qui ne sont pas solidaires du circuit imprimé là où ne se trouvent pas de couches adhésives, compense sensiblement l'allongement dudit circuit imprimé. Par conséquent, on ne constate plus avec une telle structure de phénomène d'arrachement des contacts électriques lorsque le circuit imprimé muni de chip-carrier est soumis à des essais climatiques, ou vibratoires.

2

0 044 247

On peut améliorer la tenue en température des circuits selon le procédé de l'invention en réalisant des contacts au-dessus des lacunes de couches adhésives ayant une forme particulière. Dans ce but, certains au moins desdits contacts ou conducteurs seront formés d'une pluralité de segments successifs non alignés. Par exemple, le conducteur pourra avoir la forme d'un V, au lieu d'être droit, dans sa zone de liaison entre le chip-carrier et le bord de la lacune de couches adhésives. D'autres formes particulières de contacts peuvent être, bien entendu, envisagées en cherchant à allonger le plus possible la zone d'amortissement de ces contacts (voir la définition de ce terme ci-dessous) de manière à permettre une plus grande dilatation desdits contacts sans provoquer leur rupture.

Lorsque le support est muni d'une couche isolante interposée entre la couche adhésive et le film métallique dans lequel sont gravés les conducteurs, ladite couche isolante possèdera de préférence des ouvertures, disposées sensiblement en regard des lacunes de la couche adhésive, lesdites ouvertures ayant des dimensions inférieures ou égales à celles desdites lacunes.

Afin d'éviter une interaction entre les différents contacts au cours de leur dilatation, la couche isolante sera découpée entre au moins certains conducteurs ou groupes de conducteurs de façon à les désolidariser les uns des autres, chaque découpe s'étendant sensiblement du pourtour de l'ouverture à celui de la lacune. Suivant la souplesse désirée, on pourra séparer chaque conducteur les uns des autres ou les maintenir groupés par exemple par groupes de deux, trois ou plus suivant la configuration de l'ensemble desdits conducteurs.

Le support pour composants électroniques obtenu selon le procédé de l'invention s'applique en particulier à la connexion des composants du type « chip-carrier » munis de plot de soudure pour leurs connexions aux conducteurs gravés, les dimensions extérieures du boîtier du chip-carrier étant comprises entre les dimensions de l'ouverture et celles de la lacune. En règle générale, les boîtiers actuels des chip-carriers sont de forme carrée. Par conséquent, l'ouverture ménagée dans la couche isolante sera elle-même de forme carrée ainsi que les lacunes, les centres de ces différents carrés étant sensiblement confondus. Afin d'obtenir une répartition uniforme des contraintes, la distance entre le pourtour de la lacune et celui du chip-carrier (ou du moins de son emplacement prévu) sera sensiblement la même sur tout le pourtour dudit chip-carrier. En règle générale, on a constaté que la distance entre le pourtour de la lacune et celui du boîtier du chip-carrier devait être environ compris entre 0,5 mm et 5 mm pour obtenir une bonne fiabilité. De préférence, cette distance aura une valeur comprise entre 1 mm et 3 mm.

La couche adhésive utilisée pour solidariser le substrat et le feuillard de cuivre éventuellement associés à la couche isolante, peut être soit constituée d'un adhésif, liquide dans la majorité des cas et à base d'une résine époxy ou polyuréthane mono ou bi-composant, appliquée sur les parties à assembler par des moyens appropriés tels que sérigraphie, enduction au rouleau ou à l'aide d'une machine à rideau, etc. L'assemblage ainsi constitué est parachevé par une combinaison de pression et de température variable selon l'adhésif retenu, ces paramètres étant généralement spécifiés par le fabricant d'adhésifs. L'assemblage du feuillard de cuivre et du substrat peut aussi être réalisé à l'aide d'un film adhésif double face encore appelé « pré-imprégné ». Ce dernier terme désigne généralement un tissu de verre enrobé d'une résine monomère ou prépolymère. On découpe alors dans ce pré-imprégné ou dans ce film adhésif les ouvertures correspondantes aux lacunes, puis on assemble le feuillard de cuivre, le pré-imprégné ou film adhésif ainsi réalisé et le substrat, sous presse et à chaud afin de permettre la polymérisation complète de la résine qui assure un collage de l'ensemble. L'utilisation d'un film adhésif se fait dans les mêmes conditions, l'opération de polymérisation n'étant dans ce cas pas nécessaire.

Selon le type d'adhésif retenu, ainsi que selon la nature du substrat, le mode de découpe des ouvertures ainsi que des séparations entre les différents conducteurs peut s'effectuer de différentes façons. Dans certains cas, on préférera réaliser cette découpe avant le collage du feuillard de cuivre et/ou de la couche isolante assemblée avec elle. Dans ce cas, cette découpe sera réalisée à l'aide d'un outil à lame comme dans le cas des circuits imprimés souples. Lorsque la découpe a lieu après l'assemblage du substrat et du feuillard de cuivre et/ou de la couche isolante, cette découpe pourra se faire soit par voie chimique soit par voie mécanique. Dans le cas d'une découpe chimique, on réalisera tout d'abord un masque de découpe par photogravure d'une couche photosensible dont les zones à découper auront été dégagées. A l'aide d'une solution alcaline, on réalisera alors l'ouverture correspondante dans la couche isolante. La découpe mécanique s'effectue comme précédemment à l'aide d'un outil à lame ou à l'aide d'un système de découpe par laser.

D'une manière générale, on a constaté que les meilleurs résultats étaient obtenus avec une épaisseur de couches adhésives comprise entre environ 5 $\mu$ et 50 $\mu$ et une couche isolante d'épaisseur comprise entre environ 5 $\mu$ et 500 $\mu$. Cette couche isolante sera de préférence choisie en un matériau tel que les polyesters, polyamides, polyimides, polyamide-imides et leurs dérivés. Des matériaux complexes comportant une couche de cuivre et un support par exemple en polyimide sont aisément disponibles dans le commerce pour la réalisation de circuits imprimés souples.

L'assemblage du film de cuivre et du film isolant, s'effectue soit par coulée de celui-ci sur le cuivre, soit par collage avec éventuellement prédécoupage des ouvertures.

Le procédé selon l'invention comporte généralement une étape de découpe d'ouvertures et/ou de séparations entre les conducteurs. La découpe des ouvertures dans le film complexe est effectuée au-dessus des lacunes par des moyens appropriés grâce à la présence des moyens de repérage desdites

3

lacunes (ces moyens sont simplement des trous calibrés ou bien des mires optiques). On procède ensuite éventuellement à l'opération de découpe entre les conducteurs ou groupes de conducteurs. Celle-ci s'effectue généralement sur une distance sensiblement égale à celle séparant le bord de l'ouverture et celui de la lacune.

L'opération de dépôt de la couche adhésive peut également consister à assembler le film de cuivre et un tissu de verre, par exemple, imprégné, donc adhésif, sur les deux faces. En cas de découpe d'ouvertures, celles-ci se font avant l'assemblage avec le film de cuivre.

Le substrat utilisé dans le cadre de l'invention est quelconque : ce peut être un support métallique recouvert de peinture isolante, une tôle émaillée, etc... De préférence, ce substrat sera un circuit imprimé multicouches.

L'invention sera mieux comprise à l'aide des exemples de réalisation suivants donnés à titre non limitatif, conjointement avec les figures qui représentent :

la figure 1, un montage connu d'un « chip-carrier » sur un circuit hybride ;

les figures 2 à 8, différentes variantes de réalisation d'un support obtenu selon le procédé de l'invention ;

les figures 9A et 9B, respectivement un substrat et un complexe film isolant feuillard de cuivre avant assemblage, selon un deuxième procédé de fabrication ;

la figure 10, les éléments des figures 9A et 9B après assemblage à l'aide d'un adhésif ;

la figure 11, le support pour composants de la figure 10 après réalisation des trous métallisés d'interconnexions ;

la figure 12, le support pour composants de la figure 11 après réalisation de l'ouverture dans la couche isolante ;

la figure 13, une vue de dessus du support de la figure 12.

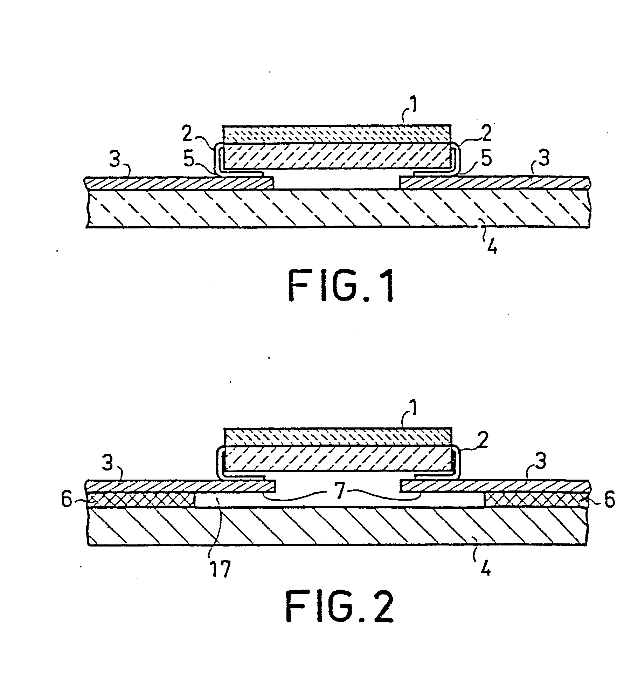

La figure 1 est donnée comme point de comparaison du montage classique d'un « chip-carrier » à substrat en céramique sur un support rigide du type céramique pour circuit hybride.

Le « chip-carrier » dans son boîtier 1 est soudé par l'intermédiaire de ses connexions de sortie 2 sur les pistes métalliques, très généralement en cuivre, 3 qui ont été précédemment déposées et gravées à la surface d'une plaque de céramique 4. Sur la figure 1, les connexions de sortie 2 sont représentées légèrement détachées du microboîtier de céramique 1, alors qu'en fait elles sont constituées par des métallisations sur les faces extérieure et inférieure du microboîtier et par conséquent totalement dépourvues de souplesse. Le microboîtier 1 et le substrat étant en céramique, les caractéristiques mécaniques et thermiques sont adaptées, et tout au moins proches les unes des autres, de telle sorte que les soudures ne travaillent pas lorsque le circuit hybride est soumis à vibrations ou à variations de température. Mais si l'on suppose que le support de céramique 4 est remplacé par un support tissu de verre/résine époxy par exemple, celui-ci présente par rapport au boîtier de céramique une souplesse qui est toute relative mais qui est cependant suffisante pour qu'il y ait arrachement ou cisaillement au niveau des soudures en 5 si le support tissu de verre/résine est soumis à une certaine déformation, qui n'est pas suivie par une déformation correspondante du microboîtier 1. On constate le même inconvénient en utilisant un support en tôle émaillée dont la flexibilité est largement supérieure à celle des microboîtiers en céramique.

La figure 2 représente l'équivalent de la figure 1 mais dans le cas où le microboîtier 1 est monté sur un support obtenu selon le procédé de l'invention.

Sur cette figure, on voit qu'un microboîtier 1 est soudé par l'intermédiaire de ses pattes de connexion 2 sur les pistes de cuivre 3 qui ont été gravées à la surface du support. Cependant, entre les pistes de cuivre 3 et le substrat 4 se trouve une couche d'adhésif 6 qui remplit une double fonction : premièrement, elle répond à la notion de couche amortisseur entre la région flexible 4 et la région rigide du microboîtier 1 ; deuxièmement, elle permet de coller la couche conductrice 3 à la surface d'un substrat 4 plus ou moins complexe, comme cela sera exposé ultérieurement. Cette couche adhésive présente des lacunes telles que 17, de telle sorte que les conducteurs de cuivre 3 sont en porte à faux dans la région 7, c'est-à-dire dans la région où ils sont eux-mêmes soudés sur le microboîtier 1.

Cette caractéristique de l'invention, c'est-à-dire l'absence de matière adhésive sous le microboîtier, est obtenue soit en déposant l'adhésif au moyen d'un masque correspondant au circuit hybride à réaliser, par sérigraphie, soit en étendant sur le substrat 4 une couche uniforme d'adhésif, dont certaines parties sont ensuite dissoutes, selon un masque qui est le négatif du masque précédent.

Le support, tel qu'il est représenté en figure 2, est obtenu par collage d'un feuillard de cuivre de 17 à 35 microns d'épaisseur environ sur un substrat classique au moyen d'un adhésif.

L'assemblage du substrat 4 et du feuillard peut être réalisé de différentes façons :

Une première solution consiste à assembler feuillard et substrat par un adhésif, liquide dans la majorité des cas, à base de résine telle qu'une résine époxy. L'adhésif est appliqué sur les parties à assembler par des moyens appropriés tels que la sérigraphie, le pistolage à travers un masque, ou le pistolage sur le substrat lui-même traité pour qu'il ait refus de colle dans les zones où l'adhésif ne doit pas exister. L'assemblage est parachevé par une combinaison d'opérations de pression et de température, variable selon l'adhésif utilisé.

Une seconde solution réside dans l'assemblage entre le feuillard et le substrat au moyen d'un film adhésif qui est constitué soit par un film sec de résine pure, partiellement polymérisé soit par un support isolant souple sandwiché entre deux couches de résine. Dans ce cas, le film adhésif est découpé avant les opérations d'assemblage puis assemblé d'une façon comparable à celle qui est utilisée pour l'assemblage précédemment cité.

Le choix de la nature de l'adhésif ou du film adhésif constituant la couche amortisseur entre les régions rigides et souples du support, est guidé par la nature des matériaux constituants les sous-ensembles du support : l'adhésif ne sera pas le même si le substrat est une tôle émaillée ou s'il est constitué d'un tissu de verre imprégné·de résine, le choix de celui-ci étant effectué par de simples manipulations de routine.

Le support obtenu après assemblage du feuillard et du substrat au moyen d'une couche de résine est alors gravé sur sa ou ses faces extérieures par les procédés chimiques classiques, ce qui permet de mettre en évidence le circuit électrique, et notamment les parties en porte à faux 7 des supports du circuit intégré dans son microboîtier 1. Il est bien entendu que le substrat 4, quelconque, peut porter une structure telle que définie par les couches 3 et 6 d'un seul côté ou des deux côtés.

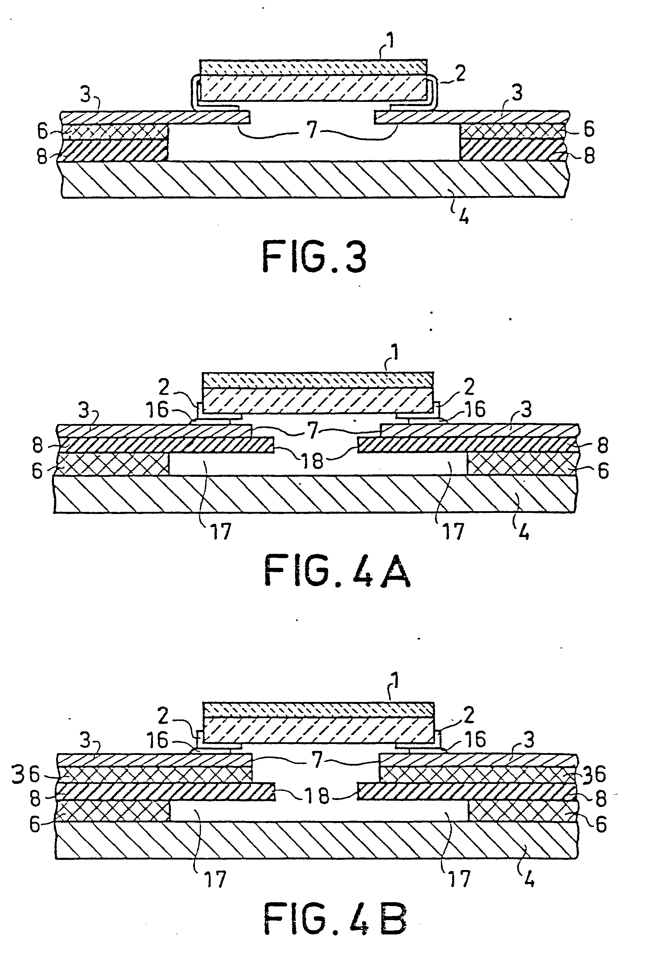

La figure 3 repésente une première variante d'un support obtenu selon le procédé de l'invention. La différence qui réside entre la figure 3 et la figure 2 consiste en l'adjonction d'une couche isolante 8 entre le feuillard 3 et le substrat 4, dans le cas où l'adhésif 6 ne se prête pas à la réalisation de couches suffisamment épaisses, ou dans le cas où les tensions électriques le nécessiteraient.

La couche isolante 8 peut faire partie d'un substrat 4 complexe multicouche, ou bien elle peut faire partie du film adhésif double face grâce auquel le feuillard de cuivre est collé sur le substrat 4. Cette couche peut elle-même présenter un vide à l'aplomb du microboîtier du circuit intégré 1 mais elle peut également être présente et c'est seulement l'absence d'adhésif 6 qui créera la région en porte à faux 7 dans les conducteurs de cuivre 3, sous le microboîtier 1. Dans cet exemple de réalisation, l'ouverture pratiquée dans le film isolant est de même dimension que celle pratiquée dans l'adhésif, compte tenu de la manière dont est réalisée cette variante.

Les figures 4A et 4B représentent une variante préférentielle du support obtenu selon le procédé de l'invention, dans laquelle un film complexe d'isolant 8 et de cuivre 3 ont été assemblés à l'aide d'une couche adhésive 6 au substrat 4. Les variantes des figures 4A et 4B sont en tout point identiques, si ce n'est que dans le cas de la figure 4A, la couche isolante 8 a été solidarisée avec la couche de cuivre 3 (par exemple par coulée de l'isolant sur le feuillard de cuivre) sans adhésif alors que dans le cas de la figure 4B, l'isolant 8 et le cuivre 3 ont été assemblés par contre-collage à l'aide d'une couche adhésive 36. Sur ces figures, cet adhésif comporte une lacune 17 comme précédemment. Le boîtier ou « chip-carrier » 1 a été représenté plus conforme à la réalité avec des pattes de connexion 2 qui sont des métallisations soudées au conducteur 3 dans la région 7 à l'aide d'un plot de soudure 16. La distance entre les conducteurs 7 est en général supérieure à la distance entre les bords 18 de l'ouverture pratiquée dans le film isolant 8, ces deux distances étant inférieures à celles séparant les bords de l'adhésif 6 et définissant la lacune 7. Dans le cas de la figure 4A, la découpe de la fenêtre 18 peut se faire par voie mécanique ou chimique par masquage sélectif. Cette déocupe peut se faire avant ou après assemblage. Dans le cas de la figure 4B, la découpe de la fenêtre 18 se fera également par des moyens chimiques ou mécaniques connus en soi. Toutefois, la réalisation la plus simple consiste à prédécouper le film isolant 8 avant de l'assembler au feuillard 3. (Il est à noter que dans le cas des figures 4A et 4B, l'ouverture 18 et la lacune 17 n'ont pas nécessairement les mêmes dimensions. Par contre, lorsqu'on utilise un pré-imprégné, adhésif double face, la lacune 17 et l'ouverture 18 dans l'isolant ont généralement les mêmes dimensions, puisque l'ouverture est pratiquée simultanément dans l'adhésif et l'isolant). Dans tous les cas, les moyens de repérage des ouvertures sont constitués par leurs coordonnées par rapport à un point de référence sur le film complexe (il en est de même des moyens de repérage des lacunes d'adhésif sur le substrat).

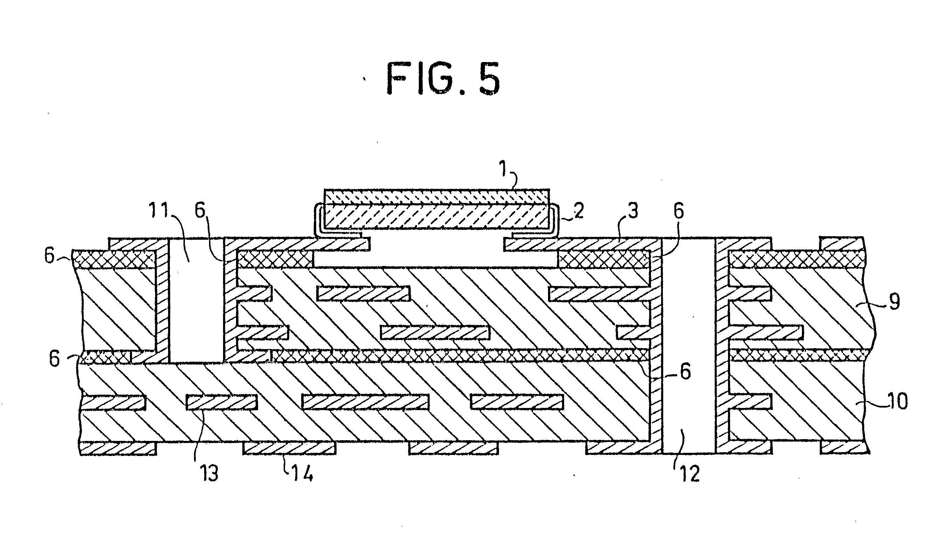

La figure 5 représente un cas plus complexe mais d'ailleurs plus concret de support pour circuit hybride obtenu selon le procédé de l'invention.

Les échelles y ont été adaptées de façon à mettre en évidence la complexité des différentes régions du support qui sont grossies par rapport aux dimensions du microboîtier 1.

Dans le cas de la figure 5, le support selon l'invention est obtenu par l'assemblage d'un premier substrat 9 complexe, qui comporte lui-même le dispositif amortisseur selon l'invention, sur un second substrat 10 complexe multicouches. En outre, pour montrer les possibilités du support selon l'invention, des trous métallisés sont représentés sur la figure 5, le trou 11 ne traversant que le premier substrat 9 multicouches, tandis que le trou métallisé 12 traverse l'ensemble du support, et est de ce fait effectué et métallisé à la fin des opérations de fabrication du support. Le support tel que représenté sur la figure 4, est donc constitué par un premier substrat multicouches 9 sur lequel a été collé un feuillard de cuivre 3 au moyen d'une première couche adhésive 6. Les opérations de perçage de ce substrat multicouches sont effectuées puis les trous métallisés et ce premier substrat multicouches 9 est collé sur un second substrat multicouches 10 au moyen d'une seconde couche du même adhésif 6.

Sur la figure sont représentés, noyés au sein des différentes couches tissu de verre époxy, un certain nombre de conducteurs de cuivre 13 ainsi qu'un certain nombre de conducteurs de cuivre 14 sur la face inférieure du support selon l'invention.

Un microboîtier 1 est représenté sur la face supérieure du support mais la même opération peut être répétée sur la face libre du substrat multicouches 10 et des microboîtiers peuvent ainsi être montés sur les deux faces du circuit hybride obtenu à la fin des opérations.

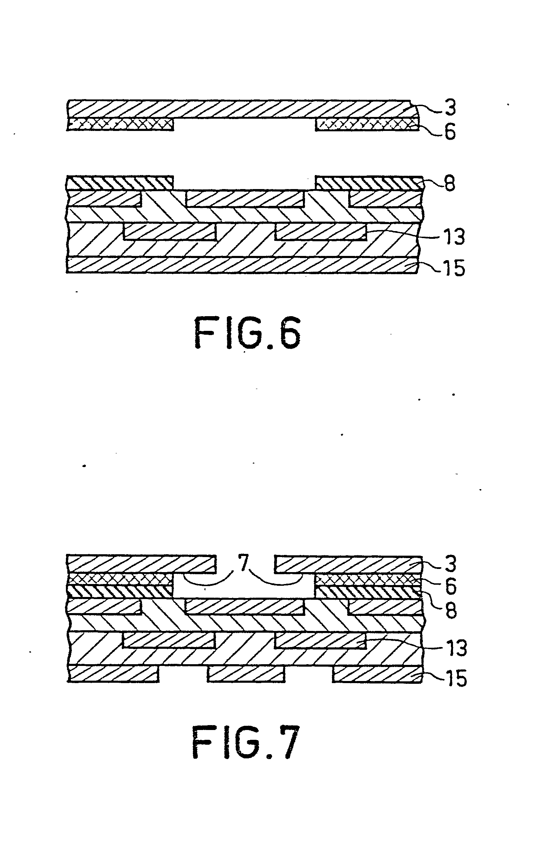

Les figures 6 et 7 représentent la fabrication du support pour circuit hybride de grandes dimensions.

Sur la figure 6, est représenté un substrat constitué d'un circuit multicouches — 3 couches sont représentées — qui a été lui-même précédemment réalisé par assemblage de plusieurs circuits monocouches, assemblage au cœur duquel circulent des conducteurs de cuivre 13, et qui comporte sur une face une couche d'isolant 8 et sur l'autre face une couche de cuivre 15 non encore gravée.

La couche d'isolant 8 peut être soit gravée soit découpée en des positions correspondant aux futures implantations de microboîtiers.

La seconde partie de l'assemblage du supprot selon l'invention est constituée par un feuillard de cuivre 3, lequel a été enduit comme il a été exposé précédemment d'une couche discontinue d'adhésif 6. L'ensemble du substrat multicouches et du feuillard enduit d'adhésif est soumis à un assemblage par pression, combinée à une température adéquate.

La figure 7 représente le même support après gravure des faces extérieures de cuivre ; dans la face de cuivre 15, sont apparus des conducteurs de cuivre 14 mais dans le feuillard 3 sont apparues des parties en porte à faux 7 après gravure puisque ces parties ne sont pas soutenues ni par la couche d'adhésif, ni par la couche d'isolant. C'est sur ces parties en porte à faux que sera soudé le microboîtier 1. Bien que, là encore, les échelles aient été dilatées de façon à faire apparaître les différentes couches constitutives du support, la soudure du microboîtier ne présente pas de difficulté car en fait si les pattes de cuivre sur lesquelles sont soudés les microboîtiers ont des longueurs de l'ordre du millimètre, le vide qui se trouve en dessous d'elles dans la partie en porte à faux 7 n'a une épaisseur que de quelques microns c'est-à-dire l'épaisseur d'une couche et/ou d'une couche d'isolant éventuellement. Par conséquent, lorsque le microboîtier est appliqué sur la couche de cuivre 3, les pattes s'affaissent légèrement au cours de la soudure puis ensuite reprennent une position normale.

Puisque la fabrication du support selon l'invention fait appel aux techniques classiques de fabrication des circuits dits imprimés, c'est-à-dire aux opérations de gravure par photomasquage, cette technique peut être utilisée en particulier pour remplacer la couche d'adhésif ou pour découper la couche isolante. La couche d'adhésif qui doit présenter des vides correspondant aux emplacements d'implantation des circuits des microboîtiers peut être remplacée par une couche de résine photosensible qui est ensuite insolée et développée, ce qui crée ainsi le vide correspondant dans la couche d'adhésif.

Quant à la couche isolante, et à condition qu'elle soit réalisée à partir de certains polymères, il est également possible de la recouvrir d'une couche de résine photosensible puis de l'insoler à travers un masque et, après développement, de dissoudre les parties correspondantes par des solutions alcalines par exemple.

L'invention permet de réaliser des circuits hybrides de grandes dimensions à partir de supports du type de ceux qui sont utilisés couramment pour les circuits « imprimés », c'est-à-dire des plaques tissu de verre/époxy ou tôle émaillée, couchées sur une ou deux face par un film de cuivre, en structure monocouche ou multicouches.

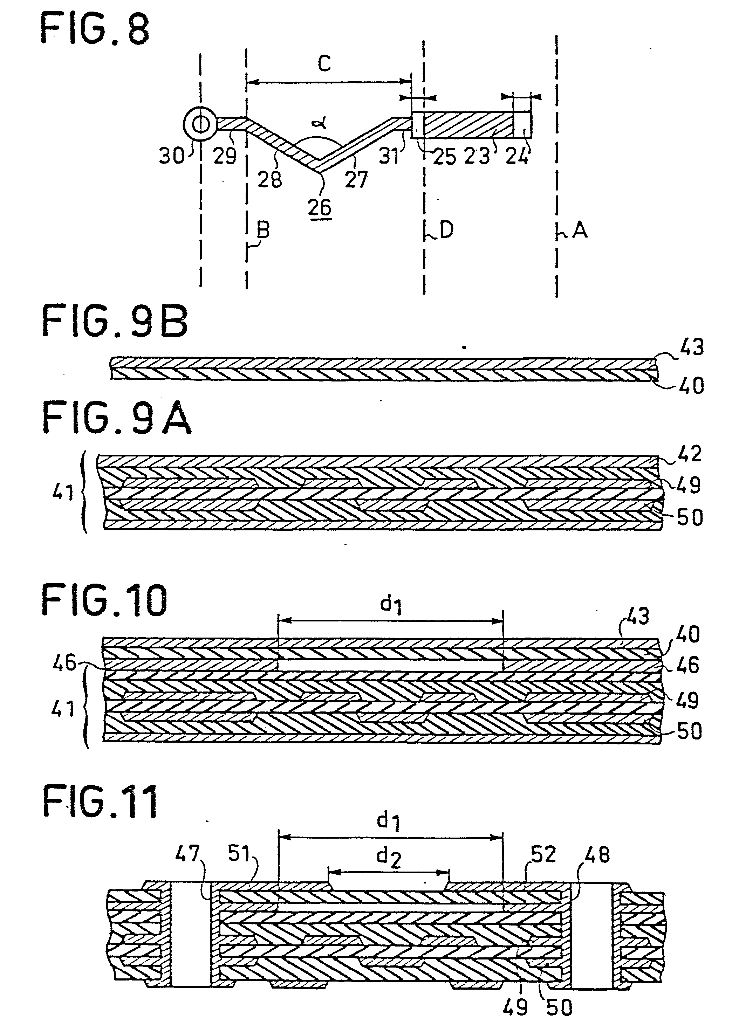

Sur la figure 8 est représenté un détail d'un conducteur utilisé dans une variante selon l'invention permettant d'obtenir encore de meilleurs résultats. Ce conducteur 26 a la forme d'un V, composé de deux bras 27 et 28 faisant entre eux un angle d'environ 150°. A titre indicatif, compte tenu de la nécessaire densité des composants sur les circuits imprimés utilisés de nos jours, cet angle $\alpha$ sera en général compris entre 120° et 180°. Le bras 28 est relié à un bras horizontal 29 lui-même connecté au trou métallisé 30. Le bras 27 est relié à un bras horizontal 31 lui-même relié à une zone de contact plus large 25. La verticale D représente la limite du boîtier du « chip-carrier » soudé sur la zone de contact 25 par sa connexion 23, tandis que la verticale A représente le pourtour de l'ouverture réalisée dans le film isolant. La verticale B représente le pourtour de la lacune d'une couche adhésive, le bras 28 se terminant sensiblement au niveau de cet axe B. La distance séparant l'extrémité de la zone de contact 25 et la verticale B sera dénommée dans toute la suite C, ou zone d'amortissement. Cette distance C est en pratique sensiblement égale à la distance séparant les verticales B et D.

Il est bien entendu que la forme en V peut être arrondie.

Sur les figures 9 à 13, sont représentées les différentes étapes de réalisation selon un mode préférentiel d'un support de composants électroniques selon l'invention.

Sur la figure 9A, on a représenté un substrat qui dans le cas présent est un circuit imprimé de type multicouches comportant des zones conductrices telles que 49 et 50 et des couches isolantes telles que 42. L'ensemble de ce substrat porte la référence 41.

Sur la figure 9B, est représenté un complexe d'une couche isolante 40 et d'une couche métallique 43. Généralement, ces deux couches sont assemblées entre elles à l'aide d'un adhésif qui n'est pas représenté sur la figure.

Sur la figure 10, est représenté le support selon l'invention réalisé par l'assemblage d'une part du substrat 41 et d'autre part du complexe 40, 43 à l'aide d'une couche d'adhésif 46. Sur une distance d1 représentée sur la figure, on note l'absence d'adhésif.

Sur la figure 11, est représenté le support selon l'invention dans une étape ultérieure de réalisation. Le support a subi d'une part les opérations de perçage habituelles afin de réaliser les trous 47 et 48 métallisés de manière connue en soi afin de relier entre eux les conducteurs des différentes couches du substrat telles que 49 et 50. Les couches superficielles du support selon l'invention ont également subi de

6

0 044 247

manière connue en soi des opérations de masquage, insolation et gravure. On a ainsi réalisé par exemple sur la couche métallique supérieure des conducteurs tels que 51 et 52, séparés entre eux d'une distance d2. Cette distance d2 est inférieure à la distance d1 représentant la dimension de la lacune de couche adhésive.

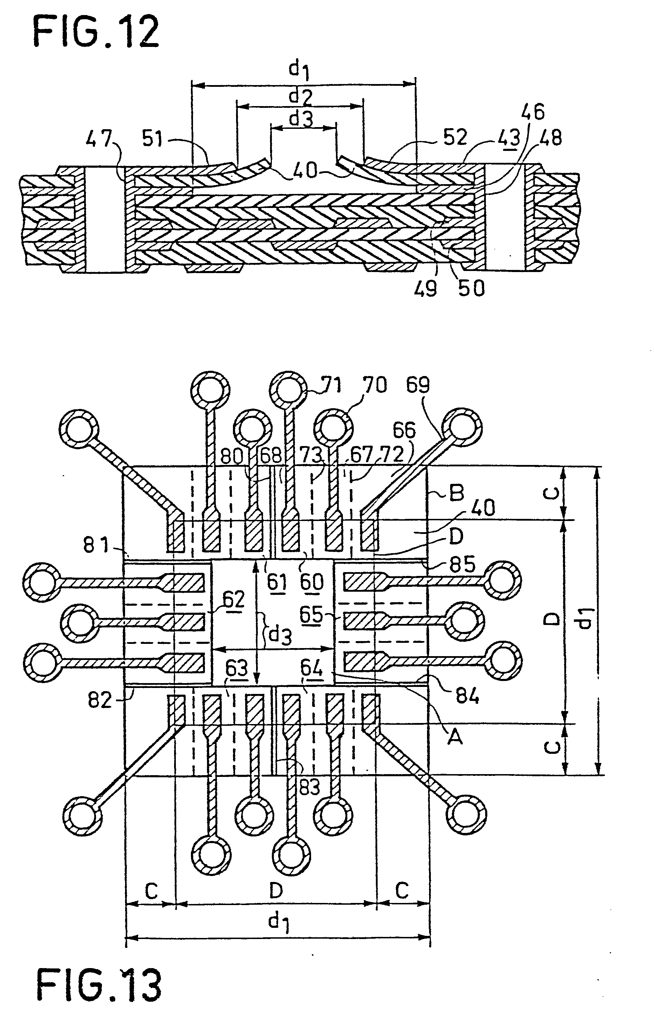

Sur la figure 12, est représenté le support selon l'invention au dernier stade de la réalisation. Une ouverture de dimension d3 inférieure à d2 a été réalisée dans la couche isolante 40. Le circuit réalisé est montré en vue de dessus sur la figure 13, sur laquelle les mêmes éléments que ceux des figures précédentes portent les mêmes références. Il est à noter que la figure 13 n'est pas reproduite à la même échelle que la figure 12. Sur cette figure, A représente le pourtour de la fenêtre réalisée dans le support isolant 40. Cette fenêtre est de dimension sensiblement carrée, le côté de ce carré ayant une longueur d3. On a également représenté sur cette figure le pourtour D du « chip-carrier » tel qu'il doit être fixé à cet endroit du circuit selon l'invention. Ce pourtour D est également de forme carrée et le côté de ce carré sera désigné dans toute la suite par D. Le pourtour de la lacune est représenté par B qui a également la forme d'un carré de côté d1 (voir figure 12). La distance séparant le pourtour D du pourtour B est égale à C ainsi que cela est représentée sur la figure. Le « chip-carrier » de pourtour D destiné à être fixé sur ce circuit comporte 18 sorties correspondant aux 18 contacts illustrés sur la figure. Ces contacts sont représentés sur cette figure groupés trois par trois en 60, 61, 62, 63, 64 et 65. Ces différents groupes de contacts sont séparés les uns des autres par des découpes s'étendant du pourtour A au pourtour B, respectivement selon les lignes 80, 81, 82, 83, 84 et 85. Chacun des groupes de contacts tels que 60 comportent donc trois contacts tels que 69, 70 et 71, gravés respectivement sur une partie isolante 66, 67 et 68, éventuellement séparées les unes des autres le long des lignes pointillées 72 et 73.

Ainsi qu'on l'a déjà souligné plus haut, la longueur C de la zone d'amortissement qui est sensiblement la longueur des contacts gravés entre le bord de la lacune B et le pourtour du « chip-carrier » D, est l'un des paramètres très important du problème résolu par le support de composants selon l'invention. A titre illustratif, on donne dans le tableau ci-dessous les dimensions des ouvertures (A), des lacunes (B), et de la zone d'amortissement (C) pour trois types de « chip-carrier » les plus courants possédant respectivement 16 sorties, 68 sorties et 128 sorties. Dans ce tableau figure également à titre de rappel la dimension habituelle (D) de ces « chip-carrier ».

| Nombre de sorties de "chip-carrier" | D mm | A mm | B mm | C mm |
|---|---|---|---|---|
| 16 | 7,62 | 4,06 | 10,41 | 1,143 |
| 68 | 24,13 | 20,57 | 27,94 | 1,651 |
| 128 | 43,18 | 39,62 | 48,00 | 2,159 |

Il est à noter que le procédé illustré sur les figures 9 à 13 (ainsi que le produit correspondant) est industriellement le plus simple et le plus économique à réaliser. De plus, le produit ainsi obtenu est très résistant mécaniquement puisque chaque conducteur métallique est renforcé par un film isolant.

**Revendications**

1. Procédé de fabrication d'un support pour composants électroniques (1) dans lequel un substrat (4) et un feuillard de cuivre (3) sont assemblés à l'aide d'une couche adhésive (6) et dans lequel des contacts électriques (7) destinés à la fixation desdits composants (1) et possédant chacun une partie en porte-à-faux de longueur suffisante pour permettre d'adapter les caractéristiques mécaniques et thermiques du support et du composant (1) sont élaborés par gravure du feuillard de cuivre (3), procédé caractérisé en ce que, avant les opérations d'assemblage, la couche adhésive (6) est réalisée de façon discontinue afin de présenter des lacunes (17) correspondant aux emplacements d'implantation de certains des composants (1), lesdites lacunes (17) ayant des dimensions supérieures à celles desdits composants (1) et étant repérées par des moyens de repérage permettant d'obtenir directement par gravure de la couche de cuivre (3) lesdites parties en porte-à-faux disposées au-dessus desdites lacunes.

2. Procédé selon la revendication 1, caractérisé en ce qu'un film isolant (8) est interposé entre le substrat (4) et le film de cuivre (3) lors de l'assemblage du film de cuivre (3) et du substrat (4).

3. Procédé selon la revendication 2, caractérisé en ce que l'on réalise des ouvertures dans le film isolant (8) de dimensions ($d_3$) inférieures aux dimensions ($d_1$) des lacunes (17) d'adhésif.

4. Procédé selon l'une des revendications 1 à 3, caractérisé en ce que le film de cuivre (3) est préalablement solidarisé avec un film isolant (8).

7

5. Procédé selon la revendication 4, caractérisé en ce que la solidarisation du cuivre (3) et du film isolant (8) est obtenue par coulée du second sur le premier.

6. Procédé selon la revendication 4, caractérisé en ce que la solidarisation du film de cuivre (3) et du film isolant (8) est obtenue par collage à l'aide d'une couche adhésive.

7. Procédé selon la revendication 6, caractérisé en ce que le film isolant (8) subit une étape de prédécoupage.

8. Procédé selon l'une des revendications 3 à 7, caractérisé en ce qu'il comporte, après l'opération de gravure du feuillard de cuivre afin d'obtenir de contacts métalliques (7), une opération de découpe entre les conducteurs et/ou groupes de conducteurs (60) sur une distance sensiblement égale à celle séparant le bord (A) de l'ouverture dans le film isolant et celui (B) de la lacune.

9. Procédé selon l'une des revendications 1 à 8, caractérisé en ce que l'opération de dépôt de la couche adhésive (6) consiste à assembler un film adhésif double face, ayant été prédécoupé pour y ménager des ouvertures, avec le substrat (4) et/ou le cuivre (3), les ouvertures ménagées dans l'isolant et les lacunes (17) de la couche adhésive ayant des dimensions identiques.

## Claims

1. Method of producing a carrier of electronic components (1), wherein a substrate (4) and a sheet of copper (3) are assembled by means of an adhesive layer (6) and wherein electrical contacts (7) for mounting said components (1) and each having a cantilever sections of sufficient length to permit an adaptation of the mechanic and thermal characteristics of the carrier and of the components (1) are formed by engraving of the copper sheet (3), the method being characterized in that, prior to the assembly operations, the adhesive layer (6) is formed in discontinuous manner in order to present voids (17) corresponding to the locations of implantation of certain components (1), said voids (17) having dimensions exceeding those of said components (1) and being marked by marking means permitting to obtain said cantilever sections arranged above said voids directly by engraving of the copper layer (3).

2. Method according to claim 1, characterized in that an insulating film (8) is interposed between the substrate (4) and the copper sheet (3) during the assembly of the copper film (3) and of the substrate (4).

3. Method according to claim 2, characterized in that openings are formed in the insulating film (8) with dimensions ($d_3$) which are smaller than the dimensions ($d_1$) of the voids (17) of the adhesive.

4. Method according to any of claims 1 to 3, characterized in that the copper sheet (3) is previously combined with an insulating film (8).

5. Method according to claim 4, characterized in that the combining of the copper (3) and of the insulating film (8) is obtained by pouring the second onto the first.

6. Method according to claim 4, characterized in that the combination of the copper sheet (3) and of the insulating film is obtained by bonding by means of an adhesive layer.

7. Method according to claim 6, characterized in that the insulating film (8) is subjected to a precutting step.

8. Method according to any of claims 3 to 7, characterized in that it comprises, in order to obtain metallic contacts (7) and subsequently to the engraving operation of the copper sheet, and operation of cutting between the conductors and/or groups of conductors (60) across a distance substantially equal to that separating the edge (A) of the opening within the insulating film from that (B) of the void.

9. Method according to any of claims 1 to 8, characterized in that the operation of deposition of the adhesive layer (6) consists in the assembly of an adhesive doublefaced film previously precut to be provided with openings, with the substrate (4) and/or with the copper (3), the openings provided within the insulating member and the voids (17) of the adhesive layer having identical dimensions.

## Patentansprüche

1. Verfahren zur Herstellung eines Trägers für elektronische Bauteile (1), bei welchem ein Substrat (4) und eine Kupferfolie (3) mittels einer Haftschicht (6) zusammengefügt werden und bei welchem elektrische Kontakte (7), die zur Befestigung der genannten Bauteile (1) bestimmt sind und jeweils einen freitragenden Teil ausreichender Länge aufweisen, um die Anpassung zwischen den mechanischen und thermischen, Kenndaten des Trägers und des Bauteils (1) zu ermöglichen, durch Gravieren der Kupferfolie (3) hergestellt werden, wobei das Verfahren dadurch gekennzeichnet ist, daß vor den Arbeitsschritten des Zusammenfügens die Haftschicht (6) diskontinuierlich ausgebildet wird, um Lücken (17) aufzuweisen, welche den Einbaustellen bestimmter Bauteile (1) entsprechen, wobei die genannten Lücken (17) Abmessungen aufweisen, die größer als diejenigen der Bauteile (1) sind und durch Markiermittel bezeichnet sind, die es gestatten, die genannten freitragenden, über den Lücken angeordneten Teile direkt durch Gravieren der Kupferschicht (3) zu erhalten.

2. Verfahren nach Anspruch 1, dadurch gekennzeichnet, daß ein Isolierfilm (8) zwischen dem Substrat (4) und der Kupferfolie (3) bei der Zusammenfügung der Kupferfolie (3) mit dem Substrat (4) eingefügt wird.

3. Verfahren nach Anspruch 2, dadurch gekennzeichnet, daß Öffnungen in dem Isolierfilm (8) mit Abmessungen ($d_3$) gebildet werden, die kleiner als die Abmessungen ($d_1$) der Lücken (17) des Haftmittels sind.

4. Verfahren nach einem der Ansprüche 1 bis 3, dadurch gekennzeichnet, daß die Kupferfolie (3) zuvor mit einem Isolierfilm (8) vereinigt wird.

5. Verfahren nach Anspruch 4, dadurch gekennzeichnet, daß die Vereinigung des Kupfers (3) mit der Isolierfolie (8) durch Aufgießen derselben auf ersteres erfolgt.

6. Verfahren nach Anspruch 4, dadurch gekennzeichnet, daß die Vereinigung der Kupferfolie (3) mit dem Isolierfilm (8) durch Klebung mittels einer Haftschicht erhalten wird.

7. Verfahren nach Anspruch 6, dadurch gekennzeichnet, daß der Isolierfilm (8) eine Vorstanzbehandlung erfährt.

8. Verfahren nach einem der Ansprüche 3 bis 7, dadurch gekennzeichnet, daß es im Anschluß an die Gravierung der Kupferfolie zum Erhalten von metallischen Kontakten (7) einen Arbeitsschritt des Zerschneidens zwischen den Leitern und/oder Leitergruppen (60) über eine Strecke umfaßt, die im wesentlichen gleich derjenigen ist, welche den Rand (A) der Öffnung in dem Isolierfilm von dem (B) der Lücke trennt.

9. Verfahren nach einem der Ansprüche 1 bis 8, dadurch gekennzeichnet, daß der Arbeitsschritt des Aufbringens der Haftschicht (6) darin besteht, einen doppelseitigen Haftfilm, der zuvor zum Anbringen der Öffnungen ausgestanzt wurde, mit dem Substrat (4) und/oder dem Kupfer (3) zusammenzufügen, wobei die in dem Isoliermittel angebrachten Öffnungen und die Lücken (17) der Haftschicht gleiche Abmessungen aufweisen.

FIG.1

FIG.2

FIG. 3

FIG. 4 A

FIG. 4 B

FIG. 5

0 044 247

FIG.6

FIG.7

# FIG. 8

# FIG. 9B

# FIG. 9A

# FIG. 10

# FIG. 11

# FIG.12

# FIG.13